(19) Europäisches Patentamt
European Patent Office
Office européen des brevets

(11) **EP 4 328 670 A1**

(12) **EUROPEAN PATENT APPLICATION**

(43) Date of publication:
**28.02.2024 Bulletin 2024/09**

(21) Application number: **22191645.5**

(22) Date of filing: **23.08.2022**

(51) International Patent Classification (IPC):
***G03F 7/20*** (2006.01)

(52) Cooperative Patent Classification (CPC):
**G03F 7/70616; G03F 7/70625; G03F 7/70633**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **SCHOLZ, Sandy, Claudia**
**5500 AH Veldhoven (NL)**

• **COENEN, Teis, Johan**
**5500 AH Veldhoven (NL)**
• **PORTER, Christina, Lynn**
**5500 AH Veldhoven (NL)**
• **VAN RIJSWIJK, Loes, Frederique**
**5500 AH Veldhoven (NL)**
• **MIDDLEBROOKS, Scott, Anderson**
**5500 AH Veldhoven (NL)**
• **HELFENSTEIN, Patrick, Philipp**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD FOR PARAMETER RECONSTRUCTION OF A METROLOGY DEVICE AND ASSOCIATED METROLOGY DEVICE**

(57) Disclosed is a method comprising: obtaining measured data relating to at least one measurement by a measurement apparatus configured to irradiate radiation onto each of one or more structures on a substrate; decomposing the measured data using a decomposition method to obtain multiple measured data components; obtaining simulated data relating to at least one simulation based on the one or more structures; decomposing the simulated data using the decomposition method to obtain multiple simulated data components; matching between at least a portion of the simulated data components and at least a portion of the measured data components; and extracting a feature of the substrate based on the matching of at least a portion of the simulated data components and at least a portion of the measured data components.

**Fig. 8**

**EP 4 328 670 A1**

## Description

<u>FIELD</u>

The present invention relates to metrology applications in the manufacture of integrated circuits.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In socalled reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

For parameter reconstruction there are generally two methods used: 1) Model based reconstruction, where both the whole sample (object of interest) and measurement system are modeled in order to get a match between observed signal (e.g. detector image) and simulated signal; and 2) Data driven reconstruction, where commonly neural nets are used to infer parameters of interest from the observed signal.

SUMMARY

According to a first aspect of the current disclosure, there is provided a method of metrology comprising: obtaining measured data relating to at least one measurement by a measurement apparatus configured to irradiate radiation onto each of one or more structures on a substrate; decomposing the measured data using a decomposition method to obtain multiple measured data components; obtaining simulated data relating to at least one simulation based on the one or more structures; decomposing the simulated data using the decomposition method to obtain multiple simulated data components; matching between at least a portion of the simulated data components and at least a portion of the measured data components; and extracting a feature of the substrate based on the matching of at least a portion of the simulated data components and at least a portion of the measured data components.

In another aspect of the invention there is provided a method of metrology comprising: illuminating a radiation onto a substrate; obtaining a measured data relating to at least one measurement of each of one or more structures on the substrate; decomposing the measured data using a decomposition method to obtain multiple measured data components; obtaining a simulated data relating to at least one simulation based on the one or more structures; decomposing the simulated data using the decomposition method to obtain multiple simulated data components; matching between at least a portion of the simulated data components and at least a portion of the measured data components; and extracting a feature of the substrate.

Optionally, the one or more structures comprise vertically stacked nanosheets and/or alternating layers with different materials.

Optionally, the one or more structures comprise gate all around (GAA) transistors. Optionally, the one or more structures comprise nanosheet structures. Optionally the nanosheet structures are comprised within a gate all around (GAA) transistor, a forksheet, and/or a complementary field effect transistor (CFET).

Optionally, the feature is a parameter of a semiconductor manufacturing process, optionally a parameter of a lithographic process and/or an etching process.

Optionally, the feature comprises lateral each depth.

Optionally, the step of matching between at least a portion of the simulated data components and at least a portion of the measured data components may further comprise adding one or more components from both the simulated data components and the measured data components into the matching.

Optionally, the method may further comprise irradiating radiation onto the substrate.

Optionally, the simulation may further be based on the at least one measurement.

Optionally, the matching between at least a portion of the simulated data components and at least a portion of the measured data components may comprise an iterative process.

Optionally, the matching between at least a portion of the simulated data components and at least a portion of the measured data components may comprise using a minimisation algorithm.

Optionally, the measured data may comprise diffracted radiation.

Optionally, the diffracted radiation may have been diffracted in reflection and/or transmission by the one or more structures on the substrate.

Optionally, the decomposition method may comprise Fourier analysis.

Optionally, depth filtering in autocorrelation space may be performed prior to performing the Fourier analysis

Optionally, the radiation may comprise one or more wavelengths in a range of 0.01 nm - 50 nm, optionally 0.01 nm - 20 nm, optionally 1 nm - 10 nm, and optionally 10 nm - 20 nm.

Optionally, the method may further comprise determining a weight matrix based on one or more properties of the at least one measurement; and applying the weight matrix to the measured data, wherein applying the weight matrix to the measured data adds a correlation to the measured data based on the one or more properties of the at least one measurement.

Optionally, the one or more properties of the at least one measurement may comprise one or more measured parameters of the measured data.

Optionally, the one or more measured parameters may comprise overlay, levelling, profilometry, alignment, critical dimension, focus, and/or dose.

Optionally, the one or more properties of the at least one measurement may comprises one or more properties of the measurement apparatus.

Optionally, the one or more properties of the at least one measurement may comprise one or more properties of the radiation used for irradiating the substrate.

Optionally, the one or more properties of the radiation may comprise wavelength, intensity distribution, and/or beam shape.

Optionally, the one or more properties of the at least one measurement may comprise one or more properties of the substrate.

Optionally, the method may further comprise applying the weight matrix to the simulated data.

Optionally, the decomposition method may comprise determining a covariance matrix for the measured data; applying the weight matrix to the covariance matrix to obtain a weighted covariance matrix; performing a singular value decomposition on the weighted covariance matrix; and obtaining the multiple measured data components based on the singular value decomposition.

According to another aspect of the current disclosure, there is provided a non-transitory computer program product comprising machine-readable instructions therein, the instructions, upon execution by a computer system, configured to cause the computer system to at least cause performance of the method as described above.

According to another aspect of the current disclosure, there is provided a computer program comprising computer readable instruction operable to perform at least the processing steps of the method as described above.

According to another aspect of the current disclosure, there is provided a processor and associated storage medium, said storage medium comprising the computer program as described above such that said processor is operable to perform the method as described above.

According to another aspect of the current disclosure, there is provided a metrology device comprising the processor and associated storage medium as described above so as to be operable to perform the method as described above.

According to another aspect of the current disclosure, there is provided a lithographic cell comprising the processor and associated storage medium as described above so as to be operable to perform the method as described above.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 comprises a flow diagram of steps in a further embodiment of the invention;
- Figure 8A comprises another flow diagram of steps in a further embodiment of the invention;
- Figure 8B comprises another flow diagram of steps in a further embodiment of the invention; and
- Figure 9 comprises another flow diagram of steps in a method of metrology taking into account properties of the at least one measurement.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

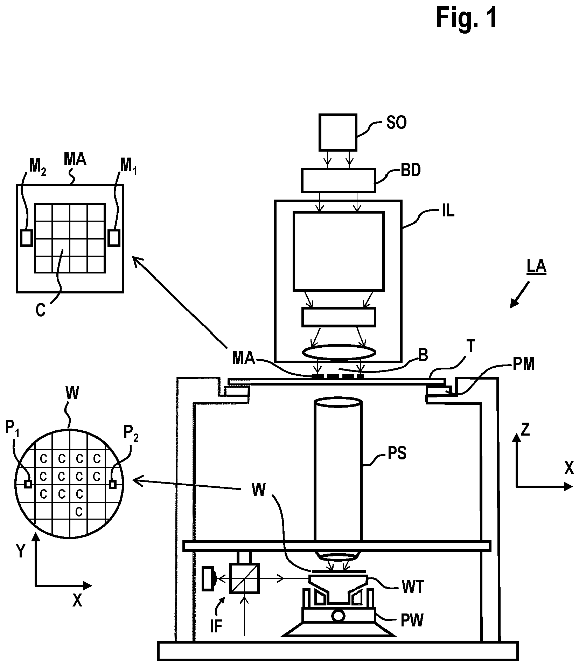

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

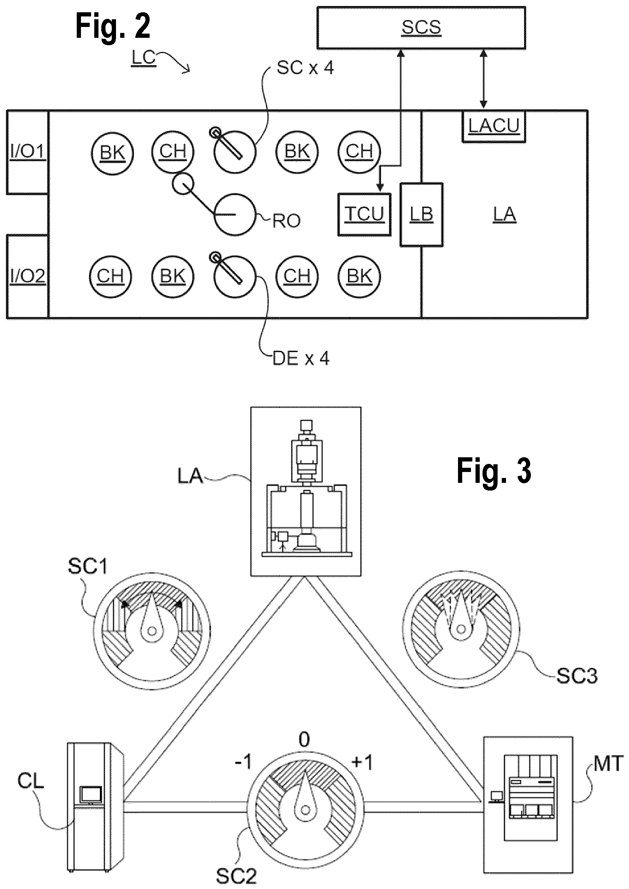

As shown in Figure 2 the lithographic apparatus LA may form part of a lithographic cell LC, also sometimes referred to as a lithocell or (litho)cluster, which often also includes apparatus to perform preand post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, an etch/etching process for example. The pitch and linewidth of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets may behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic patterning apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analyzing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

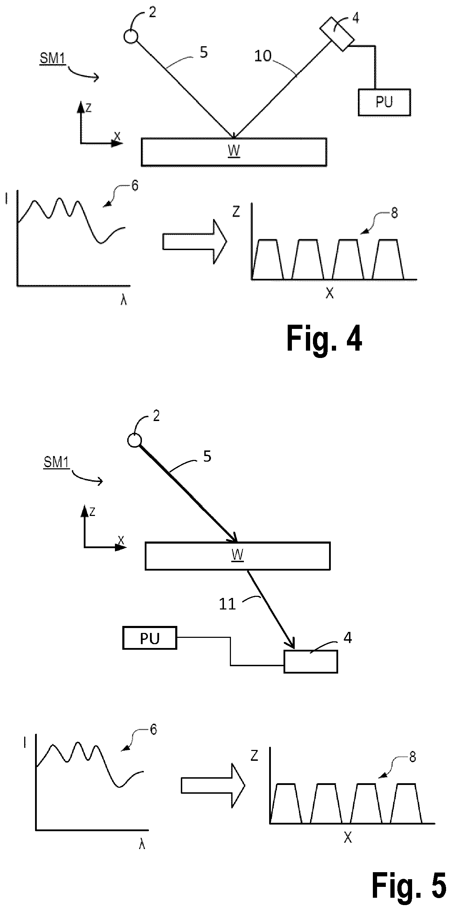

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

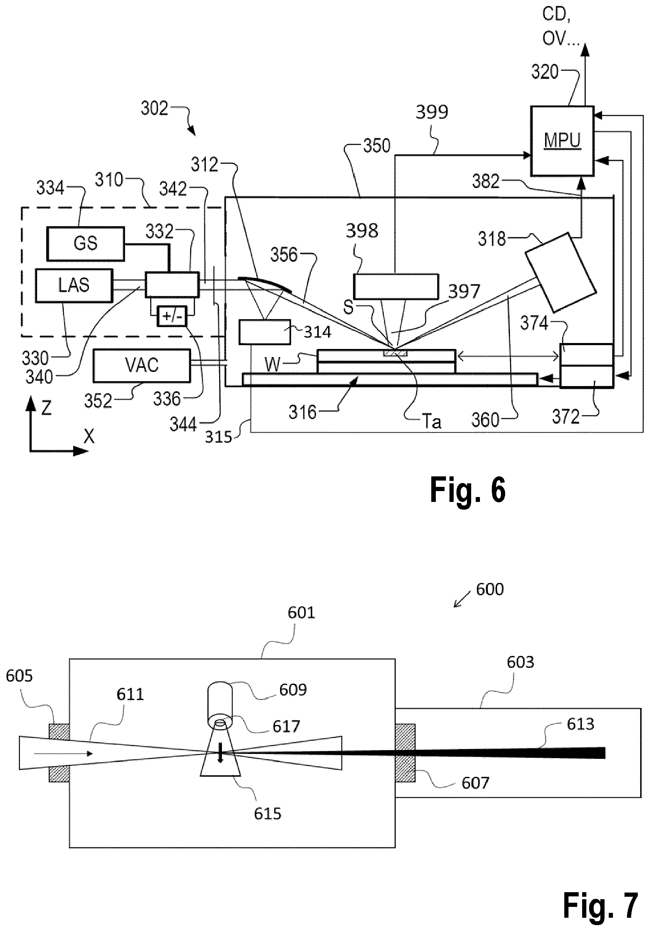

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a solid source with a solid medium for HHG generation, a gas jet/nozzle source, a capillary/fiber source, or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10$\mu$m, for example in the region of 1 $\mu$m (1 micron). Optionally, the laser pulses are delivered as a first pump radiation 340 to the gas delivery system 332, wherein in the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths may, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 μm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which may be a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 may convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV, SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

The above-mentioned apparatuses may be used for obtaining signals for parameter inference using method embodiments, which are mentioned in the above and/or following texts, and/or causing performance of the method embodiments.

For model-based reconstructions one may need to gain knowledge of the complete measurement system, via calibration measurements. These may include offline calibrations for static system parameters as well as online calibrations for varying parameters. These parameters may be used in forward modelling together with the sample parameters. These sample parameters, some of which may be parameters of interest (POIs), for example overlay after develop and/or after etch, focus, CD, (3D) edge placement error (EPE), side wall angle, tilt angle, etch depth, height, thickness, and (3D) profilometry, while others may be nuisance parameters, are floated in the forward modelling. A goal may be to get the simulated signal to agree with the measured signal and hence get the POIs that best describe the measurements. This approach has the following disadvantages:

- A lot of system knowledge needs to be available to get agreement between simulation and measurement;
- Fluctuating system parameters need to be monitored and included in the forward model;
- Depending on the optimization, a lot of sample parameters (POIs and nuisance) have to be floated for complex structures like nanosheets.

For data driven approaches large (convolutional) neural nets (CNNs) or variational auto encoders (VAEs) have to be trained. After training a measured input signal may be parsed through them and report the POIs. In order to be able to account for complex sample structures and measurement setups, both CNNs as well as VAEs may require many layers with high numbers of nodes. Hence, the number of weights that have to be trained is easily in the order of $10^6$. In order for the training to be successful a large number of labelled reference data needs to be provided. This is inherently difficult as often simple simulations are not enough as they do not cover the expected range of variation in the measurement system or the sample structure. Also labelled data in form of e.g. TEM images is expensive and time consuming. Training with suboptimal reference data may lead to wrong POI inference which is hard to detect due to the black box mode of CNN and VAE. Training of a neural nets or VAEs with simulated data can also be attempted to supplement available labelled reference data, but in this case the challenges of sensor calibration reappear.

In order to relax the requirement of the model-based reconstruction to know the measurement system and the sample structure with very high accuracy, the following hybrid model based reconstruction approach may be used that is based on the model-based approach:

- One or more POIs may be perturbed in the sample set that may be measured (this can also be through natural variation such as spatial fingerprints on the substrate).
- The measurement data (e.g. detector images) is decomposed using a decomposition method that identifies dominant variations in the data set, for example by principal component analysis (PCA) or independent component analysis (ICA). More information on the decomposition method is given in patent application EP21209747.1, which is incorporated herein by reference in its entirety.

o Fourier analysis may also be used to access the dominant components, for example by depth filtering in autocorrelation space before performing the decomposition. More information on depth filtering in autocorrelation space techniques is given in WO2021121906A1, which is incorporated herein by reference in its entirety.
o Each PCA/ICA component is associated with a variation (perturbation of a POI) in the measured data. If multiple parameters are varying in the dataset in a correlated manner, PCA may not split the signal perfectly (i.e. component 1 = recess etch, component 2 = hard mask height). But this may be acceptable. The principle components may always pick out the dominant variations in the signal, which may be easier to match to simulations than raw detector images.

- A simulation is performed on a nominal stack matching the measured stack, optionally the measured stack and sensor properties, which optionally can be practically known. The simulation may be performed with input (geometry) parameters for the simulation. The simulation may only coarsely represent the real system. For example, details may be lacking from the simulations, like edge rounding or line edge roughness. Sensor properties such as the spectral weights of the illumination beam may also be only coarsely approximated in the simulation. However, the same dominant variations (perturbations) as in the measurement data may be present in the simulated dataset.
- A decomposition may be applied in the same or similar way as for the measurement data (i.e. PCA or ICA). Note that this in contrast to some other usages e.g. as described in EP2020621A1, where the PCA components derived from the simulation were also used for data reduction in the measured data.
- A cost function may be computed. The cost function may reflect the difference of projection of each individual component, optionally the PCA component, as a function of the parameter perturbation, between the measured and simulated case.

$$Cost = \sum_{i,j} \left( a_{i,j}^{sim} - a_{i,j}^{meas} \right)^2$$

, where i is the index over the PCA components and j the index of the perturbation. An additional weight function $w_{i,j}$ might be applied to speed up convergence.

- A suitable minimization algorithm may update the input (geometry) parameters for the simulation, and the process may be iterated. This optimization is thus hunting only for the dominant variations in the measurement set, as opposed to a perfect match between the simulated and detected raw data.
- An iterative reconstruction procedure may be followed. In one example, at least a portion of, e.g. the first or first few, PCA/ICA components are included in the optimization. Once the model has coarsely converged, one or more additional components may be added to the cost function and increased detail added to the simulated sample to get an increasingly detailed match between the model and the measurements.

One embodiment is to use the above-mentioned method to measure lateral etch depth of gate all around (GAA) transistors. GAA is a modified transistor structure where the gate contacts the channel from all sides. GAA devices may use vertically stacked nanosheets, which are constructed of separate horizontal sheets, surrounded by gate materials on all sides. Superlattice of alternating layers with different materials e.g. Si and SiGe layers, form the basis for the nanosheets. Critical steps include a channel release etch to remove sacrificial layers e.. the SiGe layers. GAA may pose significant metrology challenges. One example is to measure different GAA structures with different lateral etch depths caused by different etch time. SXR is sensitivity to etch depth and enables monitoring/control of individual nanosheets, while most traditional techniques only give average properties. SXR may also be used for hard mask height measurement and individual etch depths can be observed with good sensitivity and parameter decorrelation.

One embodiment is to use the above-mentioned method to measure lateral each depth of vertically stacked nanosheets and/or alternating layers with different materials. The vertically-stacked nanosheets and/or alternating layers with different materials may be part of a gate all around (GAA) transistor, a forksheet transistor (also referred to as a forksheet FET), and/or a complementary field effect transistor (CFET). These structures (GAA, forksheets, and/or CFETs) may have similar profiles that are challenging for visible light measurements. The embodiments mentioned throughout this disclosure that apply to GAAs, may also be applicable to forksheets and/or CFETs. In forksheets, both nFET and pFET may be integrated into the same structure, in which a dielectric wall may separate the nFET and the pFET. CFETs may be considered a more complex version of a GAA. Compared to a GAA, in a CFET both the nFET and pFET wires may be stacked on each other to reduce the active area footprint.

The embodiments may rely on POIs varying, which may be the case as they are the parameters that need monitoring. To set up a coarse nominal model and determine which parameters are dominantly varying in the measured data, having access to a limited reference dataset (such as TEM or cross sectional SEM images of the actual structures) may help to ascertain that relevant varying parameters are included in the modelling, while static or random deviations can be ignored in modelling.

A power in this method is that no detailed knowledge or monitoring of the measurement system is needed as we can assume fluctuations due to slightly incorrect settings may only appear in higher PCA/ICA components and these are not further processed. Similar arguments apply to small sample structure deviations that do not have to be included in the parameter sweep as they are in full model based reconstruction. Compared to a full data driven approach no large-scale training set with enough variation is needed. Model based reconstruction via decomposition method trend fitting enables use of coarse model and minimal e.g. sensor calibration.

In one embodiment, a method is to fit a model to measurements on PCA coefficients-behaviour only (neglecting the mismatch between the components, to circumvent a tedious calibration).

Our results show that the approach led to excellent agreement between measurements and simulations and allowed for reconstruction of etch depth per measurement point and sample. The resulting fluctuations were in the range expected. The height changes needed in simulation were also in agreement with the expected fluctuation across the wafer. Agreement between simulation and second PCA component is also observed. None of the original two approaches (model-based reconstruction and data driven reconstruction) were able to deal with the lack of system knowledge and limited reference data.

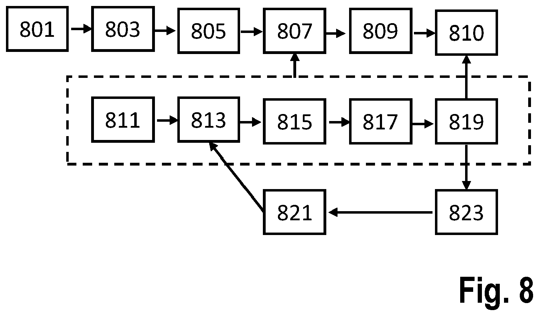

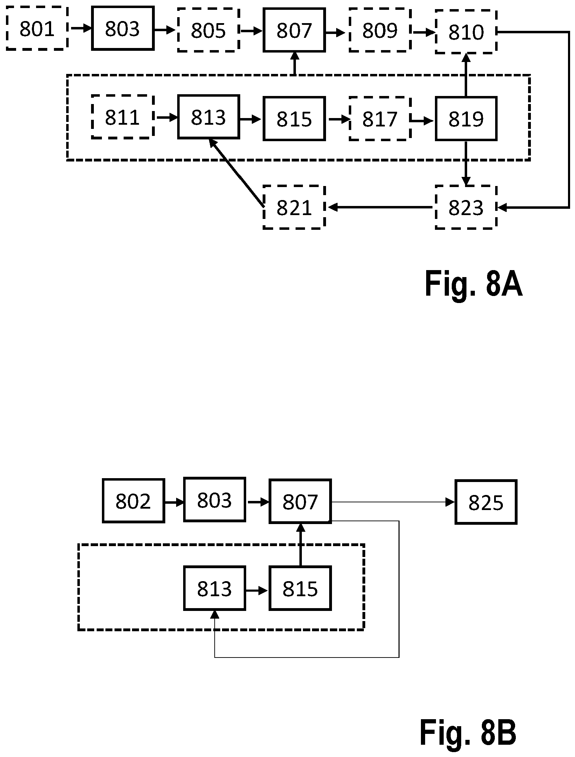

An example of a method of such a hybrid model-based reconstruction is shown in Figure 8. The method comprises step 801 which is illuminating a radiation onto a substrate and measuring a measured data and with one or more detectors. The measured data relates to at least one measurement of each of one or more structures on the substrate. The one or more structures may be perturbed structures (e.g. perturbation of one or more POIs). In the example of measuring lateral each depth of GAA structures, the perturbation may be different lateral etch depths caused by different etch time. The data may be measured for example at the pupil or image plane of an apparatus. The data may additionally and/or alternatively be measured in a different plane to the pupil plane and the image plane.

The method comprises step 803 which is decomposing the measured data to get multiple measured data components using a decomposition method. The decomposition method identifies dominant variations in the measured data. For example, the decomposition method is principal component analysis (PCA) or independent component analysis (ICA). Optionally Fourier analysis may also be used to access the dominant components, for example by depth filtering in autocorrelation space before performing the decomposition. Each PCA/ICA component is associated with a variation (i.e. the perturbation of the one or more POIs) in the measured data.

The method comprises step 805 which is projection of at least a portion of, e.g. the first or the first few, the components of the measured data resulted from the decomposition method on detector signals.

The method comprises step 811 which is inputting nominal parameters and performing a simulation on a nominal stack. The nominal parameters may comprise stack parameters and/or apparatus, e.g. sensor, detector, and optics, parameters.

The method comprises step 813 which is obtaining a simulated data relating to at least one simulation based on the one or more structures. In step 813, multiple perturbed stacks (e.g. the perturbation of one or more POIs) may be simulated to obtain the simulated data. In the example of measuring lateral each depth of GAA structures, the perturbation may be different lateral etch depths. In one example, the simulation is further based on the at least one measurement.

The method comprises step 815 which is decomposing the simulated data using a decomposition method to get multiple simulated data components. The decomposition may be in the same or similar way as in step 803.

The method comprises step 817 which is projection of at least a portion of, e.g. the first or the first few, the components of the simulated data resulted from the decomposition method on detector signals. The step 817 may be in the same or similar way as in step 805. Optionally the step 817 is projection of at least a portion of, e.g. the first or the first few, PCA components on 4 detector signals.

The method comprises step 807 which is computing the cost function. The cost function may reflect the difference of projection of each individual component as a function of the parameter perturbation, between the measured and simulated data.

The method comprises step 809 which is getting average projection for each parameter perturbation. In the example of measuring lateral each depth of GAA structures, the step 807 may be getting average projection for each lateral etch depth.

The method comprises step 819 which is shifting and or scaling the components for optimal match between results of the simulated and measured data.

The method comprises step 810 which is matching between at least a portion of, e.g. first or first few, the simulated data components and at least a portion of the measured data components.

The method comprises step 823 which is evaluating least-squares cost of the fit, optionally in the 4 points.

The method comprises step 821 which is updating the input (geometry) parameters for the simulation using a suitable minimization algorithm. The process may be iterated via an iterative reconstruction procedure e.g. feeding the result of step 823 to the step 813.

After the steps of Figure 8, a feature of the substrate is inferred/extracted. The feature may be a POI. The feature may be a parameter of the manufacturing process mentioned above, optionally a semiconductor manufacturing process, optionally the lithographic process and/or the etching process. The feature of the substrate comprises the parameters/features of the structures on the substrate.

In Figure 8, all the steps are optional, and one may choose at least a portion of the steps for metrology application. For example, one or more of steps 809, 810, 811 and 819 may be optional and be skipped.

Figure 8A shows an example method of such a hybrid model-based reconstruction with optional steps removed. As an alternative to illuminating radiation onto the substrate of step 801 to obtain the measured data, the measured data may also be obtained otherwise. The method comprises step 803, decomposing the measured data to get multiple measured data components using a decomposition method. Simulated data is also obtained 813, and decomposed 815, as set out above. In step 807 the cost function is computed for the measured and simulated data components, in order to match at least a portion of the simulated data components to at least a portion of the measured data components. The matching may be comprised in the step 807, and does not need to be set out in a separate step 810 of figure 8. Based on the cost function, the simulated data may be shifted and scaled to achieve a closer match.

Figure 8B shows a further example method including some method steps which may be used alternatively or additionally to those set out in figures 8 and 8A. In step 802 measured data is obtained. The measured data is decomposed according to step 803 described above. Simulated data is similarly obtained 813 and decomposed 815 as set out above. The cost function is determined 807, and used to update (e.g. scale and/or shift) the simulated data to achieve matching. The updated simulated data may then be provided as obtained data and decomposed for further matching. This may be an iterative process. Once the matching process is complete, one or more features of the substrate and/or the structure on the substrate may be extracted 825 based on the matched simulated data.

The process of calculating the cost function and updating the simulated data components in order to match the simulated data components to the measured data components (i.e. by reducing the cost function) may be an iterative process, as depicted by the arrows in figures 8, 8A, and 8B. The matching process may comprise using a minimisation algorithm for reducing the size of the cost function, by adapting/scaling the simulated data.

In one embodiment, the radiation used to obtain the measured data (the measurement radiation) may comprise on or both of hard X-ray or soft X-ray radiation. That is to say, the measurement radiation may comprise one or more wavelengths in a range of 0.01 nm - 50 nm, optionally 0.01 nm - 20 nm, optionally 1 nm - 10 nm, and optionally 10 nm - 20 nm. The advantages of using HXR and/or SXR over longer wavelength light, e.g. visible light, for the-above mentioned methods: 1. For shorter wavelength light, the signal is more information rich, as there are propagating orders, which helps with getting a higher sensitivity; 2. There is excellent decorrelation in HXR and/or SXR signals, which does not work as well in visible light region.

The measured data may comprise diffracted radiation captured by one or more detectors. The radiation may have been diffracted by the structure on the substrate to be measured. The radiation may have been diffracted in reflection, in transmission, or in both reflection and transmission. In some examples, the structure may be a metrology target. The structure may comprise one or more diffraction gratings.

An embodiment may include a computer-readable recording medium having stored thereon a computer program product comprising machine-readable instructions for causing a processor to perform the controlling steps of the methods mentioned above. An embodiment may include a non-transitory computer program product comprising machine-readable instructions therein, the instructions, upon execution by a computer system, configured to cause the computer system to at least cause performance of the methods mentioned above. An embodiment may include a computer program containing one or more sequences of machine-readable instructions describing a method of optical metrology, a method of POIs inference, a method of model-based reconstructions and/or a method of analyzing a measurement to obtain information about a lithographic process or other manufacturing process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the method described herein. The computer program or code may optionally be arranged to control the optical system, substrate support and the like to perform a method of measuring a parameter of the lithographic process or other manufacturing process on a suitable plurality of targets. The computer program or code can update the lithographic or other manufacturing process and/or metrology recipe for measurement of further substrates. The computer program or code may be arranged to control (directly or indirectly) the lithographic apparatus or other manufacturing apparatus, e.g. etcher, for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Signals, such as images, can be decomposed using a Singular Value Decomposition method (SVD) of the covariance matrix. SVD may decouple the relevant portion of the signal from noise and/or nuisance parameters present in the signals or images. The dominant components of SVD, that is to say the components related to the largest singular values, may be assigned to the parts of the signal that explain the most variation in the signal. For example, if the main variation in the design of the measurement is overlay (OVL) variation, the first (largest) component of SVD may most likely relate to variations correlating to overlay OVL. This may be because overlay may be the biggest contributor to changes in the signal. This first component may then be used to infer knowledge about the signal or image. SVD may also be used to clean a signal.

While SVD is a powerful tool, it does not use a priori information. For example, one source of a priori information for images is the relation of detector pixels to each other. SVD may take into account the correlation of all pixels on the detector which provided the signal to be decomposed. The correlation between pixels may be taken into account regardless of the position of those pixels relative to each other. However, in reality some pixels across the detector may have a higher correlation to some pixels than others (e.g. proximate pixels, pixels along a periodically repeating pattern at relevant frequencies, etc.). It would be desirable to improve the SVD method by taking into account physical information about the signal. Therefore, it is proposed herein to only consider those elements of the covariance matrix for which a relation is expected, based on the physical properties of the measured setup. As a simple example, one could only look at pixels in a recorded diffraction pattern that can be related to peaks of the known spectrum of the applied radiation source. Any pixels not related to those peaks may be assumed to only record noise and may be discarded a-priori in the decomposition.

An example situation in which a priori information may be useful for determining correlation is as follows: an example soft X-ray (SXR) tool may expose targets using multiple wavelengths simultaneously. This multi-wavelength exposure may for example be possible because of the HHG source used, which produces a range of higher-harmonics of the drive laser that lie between -12-18 nm, leading to an information-rich signal. The broadband SXR radiation can therefore provide depth information in a single shot. Radiation from the source may be diffracted from a target structure, wherein the angle of diffraction may be dependent on the wavelength of the radiation. Due to this wavelength-dependent positioning, the observed spots at the (pixelated) detector can be related to a harmonic, and wavelength. A pair of diffraction orders related to a specific wavelength only correlate with each other, and not with other diffracted radiation. Furthermore, the diffracted signal related to different harmonics (i. e. wavelengths) should not correlate. Therefore, it may be beneficial for the decomposition of the signal incident on the full detector to take this physics-based information into account. More generally, a priori information about the detector, the radiation, the structure, the substrate, and/or any other feature of the setup may provide an advantage when taken into account when performing the decomposition.

Described herein is a method for adapting a singular value decomposition of the measured data, using a weight matrix representing physical information about the metrology setup used to obtain the measured data. The physical information may also be referred to as properties of the at least one measurement.

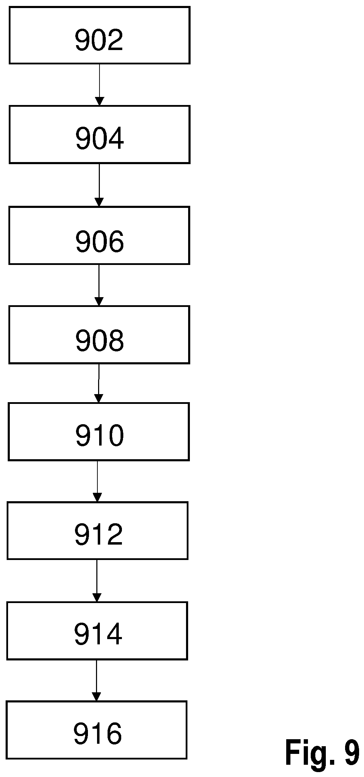

Figure 9 depicts a method comprising obtaining 902 measured data relating to at least one measurement by a measurement apparatus configured to irradiate radiation onto each of one or more structures on a substrate. In step 904 a weight matrix may be determined, based on one or more properties of the at least one measurement. The weight matrix may be applied 906 to the measured data. Applying the weight matrix to the measured data may a correlation to the measured data based on the one or more properties of the at least one measurement. In step 908 the measured data is decomposed using a decomposition method (as set out above) to obtain multiple measured data components. Simulated data relating to the at least one simulation based on the one or more structures is obtained 910, and decomposed 912 using the same decomposition method as that of the measured data, to obtain multiple simulated data components. In step 914 a matching process between at least a portion of the simulated data components and at least a portion of the measured data components is performed. Once the at least a portion of the simulated data components matches the at least a portion of the measured data components, a feature of the substrate may be extracted 916 based on the matching. The feature may be extracted based on the matching simulated data components, and/or based on the simulated data.

The properties of the at least one measurement may comprise one or more measured parameters of the measured data, relating to the structure on the substrate. The one or more measured parameters of the measured data may for example comprise overlay, levelling, profilometry, alignment, critical dimension, dose, polarization, and/or coherence information for the radiation parameters. The one or more measures parameters may for example comprise one or more properties of the measurement apparatus. The one or more measures parameters may for example comprise one or more properties of the radiation used for irradiating the substrate. The one or more properties of the radiation may for example comprise wavelength, intensity distribution, and/or beam shape. The one or more measures parameters may for example comprise one or more properties of the substrate.

Next to applying the weight matrix to the measured data, as described above, the weight matrix may also be applied to the simulated data in a corresponding way. That is to say, the weight matrix may be applied to the simulated data prior to decomposition of the simulated data.

Applying a weight matrix to a singular value decomposition may involve determining a covariance matrix for the measure data, and applying the weight matrix to the covariance matrix to obtain a weighted covariance matrix. The singular value decomposition may then be performed on the weighted covariance matrix, such that multiple measured data components are obtained based on the singular value decomposition.

An example singular value decomposition taking into account one or more properties of the measurement may be performed as follows:

1) $Z = X - \overline{X}$, wherein X = measured data, $\overline{X}$ = mean
Data is centered Z round the mean
2) $C = Z \cdot Z^T$
A covariance matrix C is created from the centered data
3) $C_{new} = nearestPD(C \cdot W)$
A weight matrix W is determined and applied to the covariance matrix. The nearest positive definite matrix is selected as $C_{new}$.
4) $C_{new} = U\varSigma U^T$
A singular value decomposition of $C_{new}$ is performed.
5) $U^* = \sum_{k=1}^{K} u_k$ , wherein $K < N$ and where N = size(U)
A number K of Eigenvectors is selected
6) $Z^* = Z\,U^*$
The components of the decomposition are defined based on the selected Eigenvectors.

In the above example decomposition, step 3 adds the weighting, based on the weight matrix described above.

The extraction of a feature 825, 916 based on the matched simulated data and/or simulated data components may be based on one or more global and/or local optimization algorithms. This may for example be based on an algorithm for minimizing the cost function to achieve matching of the measured and simulated data components.

In an example implementation, overlay measurements data may be obtained, and simulated overlay data may be obtained. The simulated data may have been obtained through a simulation that has been set so as to represent the measurement through which the measure data was obtained. The measured data may comprise of diffracted radiation captured by one or more detectors. Correspondingly, the simulation may output simulated diffraction images, which may form the simulated data. In an example setup, the diffracted pattern may form a single line (e.g. a horizontal line) along which the different diffraction orders are placed side by side. In some instances the line may be curved. The curve of the line may be gentle, so that the diffraction pattern maintains a dominant direction.

The simulated data may be pre-processed using standard methods. In one example pre-processing step, a two-dimensional (2D) simulated diffraction image, may be reduced to one-dimensional (1D) data. This may for example be achieved by summing the 2D diffraction image along the vertical axis. The summing may be of intensities of diffracted radiation along the vertical direction of the 2D image. Vertical in this context may be understood to mean in a direction perpendicular to a dominant direction (horizontal) along which a diffraction pattern is formed.

In the 1D representation, peaks may be present. Based on physical knowledge of diffraction patterns, different peaks may be associated with difference wavelengths and/or wavelength ranges. If a singular value decomposition was performed based on the 1D image, every pixel/data point of the 1D representation would be considered in relation to every other pixel/data point in the 1D representation. This means that a decomposition would be performed based on the covariance between every pixel in the signal. However, based on the physical knowledge of diffraction patterns, we know that the some areas are correlated while other areas have no correlation (e.g. pairs of positive and negative diffraction orders on opposite sides of the zeroth diffraction order may be correlated). It may be preferable to have a decomposition that only takes into account correlations between plausibly correlated pixels.

In order to use this physical knowledge about the diffraction pattern, a weight matrix may be determined, that mathematically captures the relation between correlated orders along positions in the 1D representation. This weight matrix may be applied to the covariance matrix, for example through a dot product. The rest of the SVD process may be performed as usual. The resulting decomposition may take into account a position-based correlation of diffraction orders.

A possible advantage of adding a priori knowledge of the diffraction signal to the decomposition method, is that the interpretation of the data may be facilitated.

Adding a priori knowledge as proposed herein and its resulting interpretability may allow to select only those parts of the signal that correspond to one or more points of interest in the data. This may help with de-noising of the data. Additionally and/or alternatively this may facilitate analysis of small-scale effects, for example by suppressing large changes visible in the data, and focussing on one or more smaller changes that are of interest. The large changes may for example be changes associated with changes in nuisance parameters.

The improved correlation of the weighted covariance may mean that more meaningful inference may be performed on the simplified/cleaned-up signal. The resulting improved decomposition may be used for signal interpretation. For example, the components with the largest contribution may provide an indication of which effects are the strongest. These may be referred to as the main components. These main components may be (mathematically) inverted back to detector space, where they may be interpretable. Based on this interpretation, inference of features of the measured data may be performed, e.g. feature extraction.

Further embodiments are disclosed in the subsequent numbered clauses:

1. A method of metrology comprising:

obtaining measured data relating to at least one measurement by a measurement apparatus configured to irradiate radiation onto each of one or more structures on a substrate;
decomposing the measured data using a decomposition method to obtain multiple measured data components;
obtaining simulated data relating to at least one simulation based on the one or more structures;
decomposing the simulated data using the decomposition method to obtain multiple simulated data components;
matching between at least a portion of the simulated data components and at least a portion of the measured data components; and
extracting a feature of the substrate based on the matching of at least a portion of the simulated data components and at least a portion of the measured data components.

2. A method of metrology according to clause 1, wherein the one or more structures comprise vertically stacked alternating layers with different materials.

3. A method of metrology according to clause 1 or 2, wherein the one or more structures comprise nanosheet structures; and optionally wherein the nanosheet structures are comprised within a gate all around (GAA) transistor, a forksheet, and/or a complementary field effect transistor (CFET).

4. A method of metrology according to any preceding clause, wherein the feature is a parameter of a semiconductor manufacturing process, optionally a parameter of a lithographic process and/or an etching process.

5. A method of metrology according to any preceding clause, wherein the feature comprises lateral each depth.

6. A method of metrology according to any preceding clause, wherein the step of matching between at least a portion of the simulated data components and at least a portion of the measured data components further comprises adding one or more components from both the simulated data components and the measured data components into the matching.

7. A method of metrology according to any preceding clause, further comprising:
irradiating radiation onto the substrate.

8. A method according to any of the preceding clauses wherein the simulation is further based on the at least one measurement.

9. A method according to any of the preceding clauses, wherein the matching between at least a portion of the simulated data components and at least a portion of the measured data components comprises an iterative process.

10. A method according to any of the preceding clauses, wherein the matching between at least a portion of the simulated data components and at least a portion of the measured data components comprises using a minimisation algorithm.

11. A method according to any of the preceding clauses, wherein the measured data comprises diffracted radiation.

12. A method according to clause 11, wherein the diffracted radiation has been diffracted in reflection and/or transmission by the one or more structures on the substrate.

13. A method according to any of the preceding clauses, wherein the decomposition method comprises Fourier analysis.

14. A method according to any of the preceding clauses, wherein depth filtering in autocorrelation space is performed prior to performing the Fourier analysis

15. A method according to any of the preceding clauses, wherein the radiation comprises one or more wavelengths in a range of 0.01 nm - 50 nm, optionally 0.01 nm - 20 nm, optionally 1 nm - 10 nm, and optionally 10 nm - 20 nm.

16. A method according to any preceding clause, further comprising:

determining a weight matrix based on one or more properties of the at least one measurement; and

applying the weight matrix to the measured data, wherein applying the weight matrix to the measured data adds a correlation to the measured data based on the one or more properties of the at least one measurement.

17. A method according to clause 16, wherein the one or more properties of the at least one measurement comprise one or more measured parameters of the measured data.

18. A method according to clause 17, wherein the one or more measured parameters comprise overlay, levelling, profilometry, alignment, critical dimension, focus, and/or dose.

19. A method according to any of clauses 16 - 18, wherein the one or more properties of the at least one measurement comprise one or more properties of the measurement apparatus.

20. A method according to any of clauses 16 - 19, wherein the one or more properties of the at least one measurement comprise one or more properties of the radiation used for irradiating the substrate.

21. A method according to clause 20, wherein the one or more properties of the radiation comprise wavelength, intensity distribution, and/or beam shape.

22. A method according to any of clauses 16 - 21, wherein the one or more properties of the at least one measurement comprise one or more properties of the substrate.

23. A method according to any of clauses 16 - 22, further comprising:
applying the weight matrix to the simulated data.

24. A method according to any of clauses 16 - 23, wherein the decomposition method comprises:

determining a covariance matrix for the measured data;
applying the weight matrix to the covariance matrix to obtain a weighted covariance matrix;
performing a singular value decomposition on the weighted covariance matrix; and
obtaining the multiple measured data components based on the singular value decomposition.

25. A method of metrology comprising:

illuminating a radiation onto a substrate;
obtaining a measured data relating to at least one measurement of each of one or more structures on the substrate;
decomposing the measured data using a decomposition method to obtain multiple measured data components;
obtaining a simulated data relating to at least one simulation based on the one or more structures;
decomposing the simulated data using the decomposition method to obtain multiple simulated data components;
matching between at least a portion of the simulated data components and at least a portion of the measured data components; and
extracting a feature of the substrate based on the simulated data.

26. A non-transitory computer program product comprising machine-readable instructions therein, the instructions, upon execution by a computer system, configured to cause the computer system to at least cause performance of the method of any of clauses 1 to 25.

27. A processor and associated storage medium, said storage medium comprising the non-transitory computer program of clause 26 such that said processor is operable to perform the method of any of clauses 1 to 25.

28. A metrology device comprising the processor and associated storage medium of clause 27 so as to be operable to perform the method of any of clauses 1 to 25.

29. A lithographic cell comprising the processor and associated storage medium of clause 27 so as to be operable to perform the method of any of clauses 1 to 25.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (nonvacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

**Claims**

1. A method of metrology comprising:

   obtaining measured data relating to at least one measurement by a measurement apparatus configured to irradiate radiation onto each of one or more structures on a substrate;
   decomposing the measured data using a decomposition method to obtain multiple measured data components;
   obtaining simulated data relating to at least one simulation based on the one or more structures;
   decomposing the simulated data using the decomposition method to obtain multiple simulated data components;
   matching between at least a portion of the simulated data components and at least a portion of the measured data components; and
   extracting a feature of the substrate based on the matching of at least a portion of the simulated data components and at least a portion of the measured data components.

2. A method of metrology according to claim 1, wherein the one or more structures comprise vertically stacked alternating layers with different materials.

3. A method of metrology according to claim 1 or 2, wherein the one or more structures comprise nanosheet structures; and optionally wherein the nanosheet structures are comprised within a gate all around (GAA) transistor, a forksheet, and/or a complementary field effect transistor (CFET).

4. A method of metrology according to any preceding claim, wherein the feature is a parameter of a semiconductor manufacturing process, optionally a parameter of a lithographic process and/or an etching process.

5. A method of metrology according to any preceding claim, wherein the feature comprises lateral each depth.

6. A method according to any of the preceding claims wherein the simulation is further based on the at least one measurement.

7. A method according to any of the preceding claims, wherein the matching between at least a portion of the simulated data components and at least a portion of the measured data components comprises an iterative process.

8. A method according to any of the preceding claims, wherein the matching between at least a portion of the simulated data components and at least a portion of the measured data components comprises using a minimisation algorithm.

9. A method according to any of the preceding claims, wherein the measured data comprises diffracted radiation.

10. A method according to any of the preceding claims, wherein the decomposition method comprises Fourier analysis.

11. A method according to any of the preceding claims, wherein depth filtering in autocorrelation space is performed prior to performing the Fourier analysis

12. A method according to any preceding claim, further comprising:

    determining a weight matrix based on one or more properties of the at least one measurement; and
    applying the weight matrix to the measured data, wherein applying the weight matrix to the measured data adds a correlation to the measured data based on the one or more properties of the at least one measurement.

13. A non-transitory computer program product comprising machine-readable instructions therein, the instructions, upon execution by a computer system, configured to cause the computer system to at least cause performance of the method of any of claims 1 to 12.

14. A processor and associated storage medium, said storage medium comprising the non-transitory computer program of claim 13 such that said processor is operable to perform the method of any of claims 1 to 12.

15. A metrology device comprising the processor and associated storage medium of claim 14 so as to be operable to perform the method of any of claims 1 to 12.

# Fig. 1

**Fig. 2**

LC

SC x 4

SCS

I/O1   BK   CH   ⊘   BK   CH

LACU

RO

TCU   LB   LA

I/O2   CH   BK   ⊘   CH   BK

DE x 4

**Fig. 3**

LA

SC1

SC3

CL

-1   0   +1

MT

SC2

**Fig. 4**

**Fig. 5**

**Fig. 6**

**Fig. 7**

Fig. 8

Fig. 8A

Fig. 8B

Fig. 9

Europäisches
Patentamt

European
Patent Office

Office européen
des brevets

# EUROPEAN SEARCH REPORT

Application Number

EP 22 19 1645

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 020 621 A1 (ASML NETHERLANDS BV [NL]) 4 February 2009 (2009-02-04) | 1-10, 12-15 | INV. G03F7/20 |
| Y | * paragraphs [0036] – [0048]; figures 2,4-6 * | 11 | |
| Y,D | WO 2021/121906 A1 (ASML NETHERLANDS BV [NL]) 24 June 2021 (2021-06-24) * the whole document * | 11 | |
| A | US 2015/235108 A1 (PANDEV STILIAN IVANOV [US]) 20 August 2015 (2015-08-20) * the whole document * | 1-15 | |

TECHNICAL FIELDS
SEARCHED      (IPC)

G03F

The present search report has been drawn up for all claims

| Place of search | Date of completion of the search | Examiner |
|---|---|---|
| Munich | 23 January 2023 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 19 1645

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2023

| Patent document cited in search report | | | Publication date | Patent family member(s) | | | Publication date |
|---|---|---|---|---|---|---|---|
| EP 2020621 | A1 | | 04-02-2009 | CN | 101382737 | A | 11-03-2009 |
| | | | | EP | 2020621 | A1 | 04-02-2009 |
| | | | | IL | 193061 | A | 27-06-2013 |
| | | | | JP | 4896092 | B2 | 14-03-2012 |
| | | | | JP | 2009124101 | A | 04-06-2009 |
| | | | | KR | 20090013733 | A | 05-02-2009 |
| | | | | SG | 145708 | A1 | 29-09-2008 |
| | | | | TW | 200916978 | A | 16-04-2009 |
| | | | | US | 7460237 | B1 | 02-12-2008 |
| WO 2021121906 | A1 | | 24-06-2021 | CN | 114902139 | A | 12-08-2022 |
| | | | | IL | 293749 | A | 01-08-2022 |
| | | | | KR | 20220103772 | A | 22-07-2022 |
| | | | | TW | 202138927 | A | 16-10-2021 |
| | | | | TW | 202227905 | A | 16-07-2022 |
| | | | | WO | 2021121906 | A1 | 24-06-2021 |
| US 2015235108 | A1 | | 20-08-2015 | CN | 106062939 | A | 26-10-2016 |
| | | | | KR | 20160124775 | A | 28-10-2016 |
| | | | | TW | 201539149 | A | 16-10-2015 |
| | | | | TW | 202018430 | A | 16-05-2020 |
| | | | | US | 2015235108 | A1 | 20-08-2015 |
| | | | | WO | 2015127220 | A1 | 27-08-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B

- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1
- EP 21209747
- WO 2021121906 A1
- EP 2020621 A1

**Non-patent literature cited in the description**

- **LEMAILLET et al.** Intercomparison between optical and X-ray scatterometry measurements of FinFET structures. *Proc. of SPIE,* 2013, 8681